# EUROPÄISCHE PATENTSCHRIFT

(11) **EP 2 138 450 B1**
(45) Veröffentlichungstag und Bekanntmachung des Hinweises auf die Patenterteilung: **22.10.2014**
(21) Anmeldenummer: 09159221.2
(22) Anmeldetag: 30.04.2009
(51) Int. Cl.: B81C 1/00

(54) **Elektrodenstruktur für ein mikromechanisches Bauelement**
Structure of electrodes for a micromechanical device
Structure des électrodes pour un élément microméchanique

(30) Priorität: 26.06.2008 DE 102008002668
(43) Veröffentlichungstag der Anmeldung: 30.12.2009
(73) Patentinhaber: ROBERT BOSCH GMBH, 70442 Stuttgart (DE)
(72) Erfinder: Benzel, Hubert, 72124, Pliezhausen (DE); Schelling, Christoph, 70597, Stuttgart (DE)

(56) Entgegenhaltungen:
- DE-A1-102005 060 855

## Beschreibung

### STAND DER TECHNIK

Die vorliegende Erfindung betrifft ein mikromechanisches Bauelement und ein entsprechendes Herstellungsverfahren.

Obwohl auf beliebige mikromechanische Bauelemente mit einem Membranbereich anwendbar, werden die vorliegende Erfindung und die ihr zugrundeliegende Problematik im Hinblick auf einen mikromechanischen Drucksensor erläutert.

Aus der WO 02/02458, der DE 10 2004 036 032 A1 und der DE 10 2004 036 035 A1 sind Drucksensoren mit piezoresistivem Wandlerprinzip und ein entsprechendes Herstellungsverfahren bekannt. Dieses Verfahren wird unter dem Begriff APSM zusammengefasst, was für Advanced Porous Silicon Membrane steht.

Des Weiteren ist es bekannt, in einem Opferschichtprozess ein Opferoxid unter einer epitaktischen Polysiliziumschicht zu entfernen, um Beschleunigungssensoren herzustellen.

Aus der US 2006/0278009 A1 sind kapazitive Drucksensoren bekannt, bei denen eine Elektrode in einem Substrat angeordnet ist und eine zweite Elektrode in einer über dem Substrat vorgesehenen Elektrodenschicht vorgesehen ist. Ungünstig an dieser Anordnung ist es, dass das kapazitive Messsignal stark nichtlinear von der physikalischen Messgröße Druck und weiteren Messparametern, wie z.B. der Temperatur, abhängt.

Aus der älteren deutschen Anmeldung DE 10 2007 029 414.1 ist ein kapazitiver Drucksensor bekannt, der eine erste und eine zweite Elektrode aufweist, wobei die erste Elektrode in eine bewegliche Membran und die zweite Elektrode in einem der Membran gegenüberliegenden Gegenelement integriert ist. Zur Erfassung eines Drucksignals wird die erste Elektrode seitlich über die zweite Elektrode bewegt.

Aus der Schrift DE 10 2005 060 855 A1 ist ein mikromechanischer Druckwandler bekannt. Dabei weist der Druckwandler eine Membran oberhalb einer Kaverne auf. Für die kapazitive Druckmessung ist das Substrat in einem räumlich begrenzten Bereich derart dotiert, dass eine erste Elektrode im Halbleitersubstrat entsteht. Die zweite Elektrode wird mittels einer flexiblen Aufhängung über der Kaverne vorgesehen.

### VORTEILE DER ERFINDUNG

Das in Anspruch 1 definierte erfindungsgemäße mikromechanische Bauelement sowie das entsprechende Herstellungsverfahren nach Anspruch 9 weisen den Vorteil auf, dass sie eine einfach herstellbare und robuste kapazitive Struktur liefern. Besonders vorteilhaft bei dem erfindungsgemäßen mikromechanischen Bauelement ist die Tatsache, dass sich aufgrund der Elektrodenstrukturen ein lineares Ausgangssignal erzeugen lässt. Es können beispielsweise Absolut-, Relativ- und Differenzdrucksensoren hergestellt werden. Ein weiterer Vorteil liegt darin, dass der Sensor einen Überlastschutz besitzt.

Die der vorliegenden Erfindung zugrundeliegende Idee besteht darin, eine erste Elektrodenstruktur auf der Membran zu verankern, und eine zweite Elektrodenstruktur auf dem Substrat neben der Membran zu verankern, wobei eine Auslenkung der Membran eine Veränderung der Kapazität zwischen der ersten und zweiten Elektrodenstruktur bewirkt.

Die in den jeweiligen Unteransprüchen aufgeführten Merkmale beziehen sich auf vorteilhafte Weiterbildungen und Verbesserungen des betreffenden Gegenstandes der Erfindung.

Gemäß einer bevorzugten Weiterbildung ist die erste Elektrodenstruktur an einem Pfosten verankert, der auf der Oberseite der Membran angebracht ist, wobei die zweite Elektrodenstruktur auf der Vorderseite des Substrats verankert ist.

Gemäß einer weiteren bevorzugten Weiterbildung ist die erste Elektrodenstruktur an einem Pfosten verankert, der auf der Unterseite der Membran angebracht ist und sich durch eine Durchgangsöffnung durch das Substrat zur Rückseite erstreckt, und wobei die zweite Elektrodenstruktur auf der Rückseite des Substrats verankert ist.

Gemäß einer weiteren bevorzugten Weiterbildung befindet der Pfosten sich an der Stelle der größten Auslenkung der Membran im Falle einer Druckbeaufschlagung, bevorzugt in der Mitte des Membranbereichs.

Gemäß einer weiteren bevorzugten Weiterbildung erstreckt sich eine Durchgangsöffnung durch das Substrat zur Rückseite, durch die externer Druck an die Membran anlegbar ist. Bei einer Ausführung des erfindungsgemäßen mikromechanischen Bauelements mit rückseitigen Elektrodenstrukturen und/oder rückseitiger Zuführung des externen Drucks lässt sich ein besonders medienresistenter Aufbau realisieren. Eine dazu erforderliche mechanische Waferdurchätzung von der Rückseite her ist besonders kostengünstig realisierbar.

Gemäß einer weiteren bevorzugten Weiterbildung weist die erste Elektrodenstruktur eine Mehrzahl von ersten Elektrodenfingern auf, und weist die zweite Elektrodenstruktur eine Mehrzahl von zweiten Elektrodenfingern auf, wobei die ersten Elektrodenfinger zwischen den zweiten Elektrodenfingern angeordnet sind.

Gemäß einer weiteren bevorzugten Weiterbildung ist eine Schutzkappe auf der Vorderseite über der ersten Elektrodenstruktur und der zweiten Elektrodenstruktur vorgesehen.

Gemäß einer weiteren bevorzugten Weiterbildung sind die erste Elektrodenstruktur und die zweite Elektrodenstruktur derart vom Substrat beabstandet, dass es bei einer Druckbeaufschlagung knapp oberhalb des Messbereichs des Sensors - je nach Druckverhältnissen auf den beiden Seiten der Membran - zu einem Aufliegen entweder der ersten Elektrodenfinger auf dem äußeren Substrat oder der zweiten Elektrodenfinger auf der Membran kommt. Durch diesen mechanischen Anschlag wird ein Überlastschutz erzielt.

### ZEICHNUNGEN

Ausführungsbeispiele der Erfindung sind in der Zeichnung dargestellt und in der nachfolgenden Beschreibung näher erläutert.

Es zeigen:
- Fig. 1a-c: schematische Querschnittsdarstellungen zur Erläuterung eines Herstellungsverfahrens einer mikromechanischen Drucksensorvorrichtung gemäß einer ersten Ausführungsform der vorliegenden Erfindung;
- Fig. 2: eine Draufsicht der mikromechanischen Drucksensorvorrichtung gemäß der ersten Ausführungsform der vorliegenden Erfindung, wobei die Linie A-A' den Schnitten gemäß Fig. 1a-c entspricht;
- Fig. 3: eine Querschnittsansicht einer mikromechanischen Drucksensorvorrichtung gemäß einer zweiten Ausführungsform der vorliegenden Erfindung; und
- Fig. 4: eine Querschnittsansicht einer mikromechanischen Drucksensorvorrichtung gemäß einer dritten Ausführungsform der vorliegenden Erfindung.

### BESCHREIBUNG VON AUSFÜHRUNGSBEISPIELEN

In den Figuren bezeichnen gleiche Bezugszeichen gleiche bzw. funktionsgleiche Elemente.

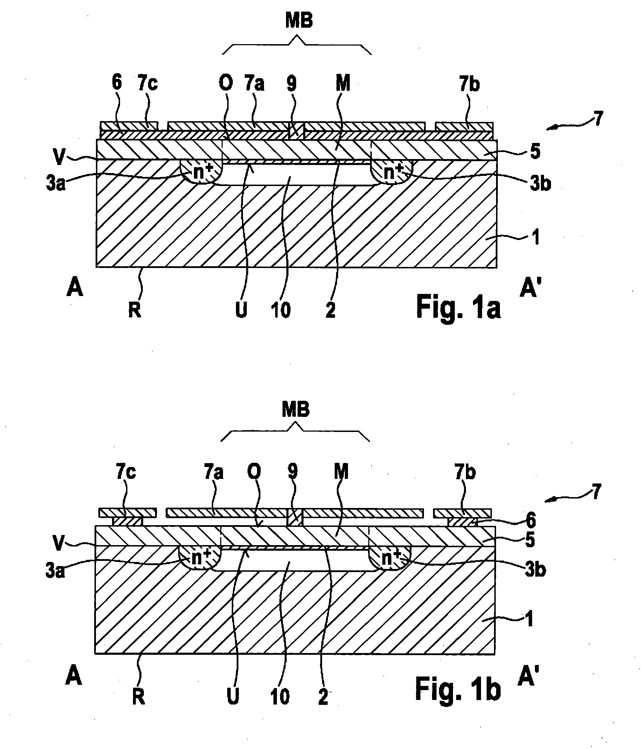

Fig. 1a-c sind schematische Querschnittsdarstellungen zur Erläuterung eines Herstellungsverfahrens einer mikromechanischen Drucksensorvorrichtung gemäß einer ersten Ausführungsform der vorliegenden Erfindung.

In Fig. 1a bezeichnet Bezugszeichen 1 ein Silizium-Halbleitersubstrat mit einer Vorderseite V und einer Rückseite R. Auf der Vorderseite V des Substrats 1 vorgesehen ist ein Hohlraum 10, der von n⁺-dotierten Gebieten 3a, 3b eingegrenzt ist. Die Herstellung dieses Hohlraums 10 erfolgt beispielsweise mittels der oben erwähnten APSM-Technologie.

Über dem Hohlraum 10, über dem sich eine dünne Siliziumschicht 2 herrührend von dem APSM-Verfahren befindet, wird eine erste Siliziumschicht 5 epitaktisch aufgewachsen, welche sich auch auf den neben dem Hohlraum 10 liegenden Bereich der Vorderseite V des Substrats 1 erstreckt. Die Siliziumschicht 5 ist leitfähig und bildet eine Membran M in einem Membranbereich MB über dem Hohlraum 10, deren Oberseite mit O und deren Unterseite mit U bezeichnet ist.

In einem anschließenden Prozessschritt wird eine Opferschicht 6 , z. B. eine thermische Oxidschicht, aufgewachsen und strukturiert. Anschließend wird die Opferschicht 6 mit einer leitfähigen Polysiliziumschicht 7 überwachsen, wobei gleichzeitig im zentralen Bereich der Membran M ein Pfosten 9 zum Verankern der Polysiliziumschicht 7 auf der Oberseite O der Membran gebildet wird.

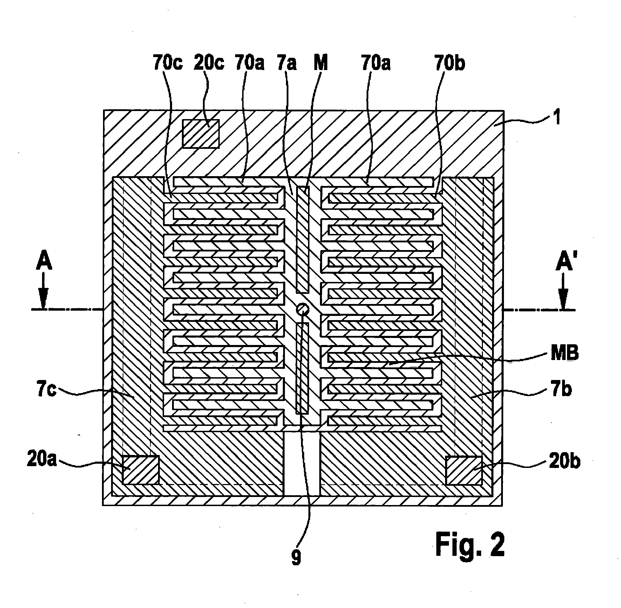

In einem folgenden Prozessschritt werden aus der zweiten Polysiliziumschicht 7 eine erste Elektrodenstruktur 7a und eine zweite Elektrodenstruktur 7b, 7c in einem entsprechenden photolithographischen Ätzschritt gebildet (vgl. Fig. 2).

Weiter mit Bezug auf Fig. 1b erfolgt nach der Strukturierung der zweiten Polysiliziumschicht 7 ein Opferschichtätzen der Oxidschicht 6, wobei das Oxid vollständig unter der ersten Elektrodenstruktur 7a entfernt wird und teilweise unter der zweiten Elektrodenstruktur 7b, 7c verbleibt, um die zweite Elektrodenstruktur 7b, 7c auf der Vorderseite V des Substrats 1 seitlich zur Membran versetzt und elektrisch davon isoliert zu verankern.

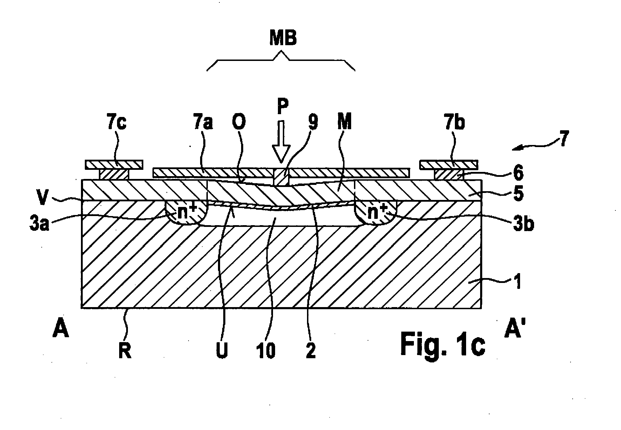

Wie in Fig. 1c dargestellt, bewirkt eine Auslenkung der Membran M beispielsweise durch Anlegen eines externen Drucks P durch die Verschiebung der ersten Elektrodenstruktur gegenüber der zweiten Elektrodenstruktur senkrecht zu der aus Ihnen gebildeten Ebene eine Veränderung der Kapazität zwischen der ersten Elektrodenstruktur 7a und der zweiten Elektrodenstruktur 7b, 7c, wodurch ein elektrisches Drucksignal erzeugbar ist. Die Bewegung der ersten Elektrodenstruktur 7a, welche nachstehend mit Bezug auf Fig. 2 näher erläutert wird, vollzieht sich dabei im Wesentlichen planparallel nach unten.

Fig. 2 ist eine Draufsicht der mikromechanischen Drucksensorvorrichtung gemäß der ersten Ausführungsform der vorliegenden Erfindung, wobei die Linie A-A' den Schnitten gemäß Fig. 1a-c entspricht.

In Fig. 2 bezeichnen zusätzlich zu den bereits eingeführten Bezugszeichen die Bezugszeichen 20a, 20b und 20c Bondpads für die zweite Elektrodenstruktur 7b, 7c bzw. das Substrat 1.

Wie aus Fig. 2 weiterhin ersichtlich, ist die erste Elektrodenstruktur 7a kammförmig aufgebaut, d. h., zu beiden Seiten eines länglichen Steges erstrecken sich parallele Kammzinken 70a in entgegengesetzte Richtungen.

Analog aufgebaut ist die zweite Elektrodenstruktur 7b, 7c, welche aus zwei Kammanordnungen mit Kammzinken 70b bzw. 70c besteht, die beiderseits der beweglichen Elektrodenstruktur 7a angeordnet sind und interdigital in die erste Elektrodenstruktur 7a eingreifen.

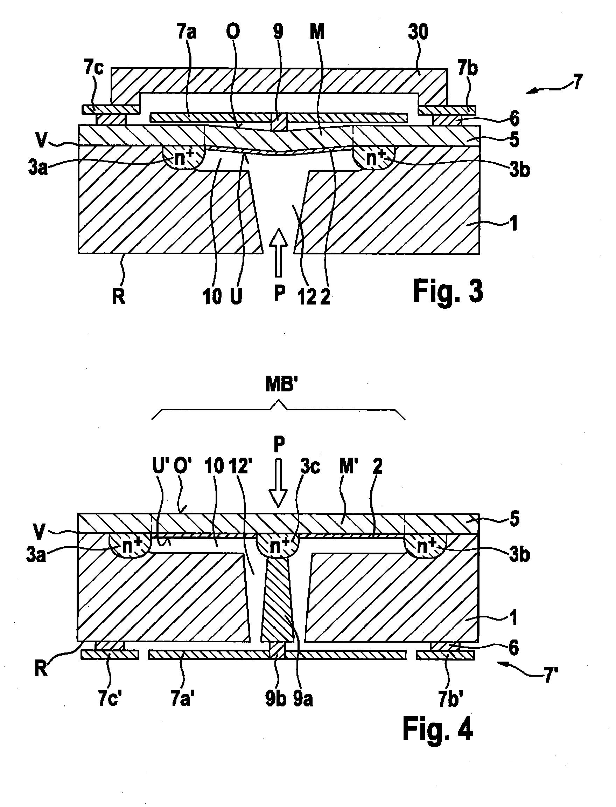

Fig. 3 ist eine Querschnittsansicht einer mikromechanischen Drucksensorvorrichtung gemäß einer zweiten Ausführungsform der vorliegenden Erfindung.

Bei der zweiten Ausführungsform gemäß Fig. 3 ist eine rückseitige Durchgangsöffnung 12 im Substrat 1 vorgesehen, durch die ein externer Druck P an die Unterseite U der Membran M anlegbar ist. Das Druckmedium wird also von der Rückseite R des Substrats 1 zugeführt, ohne dass die elektrischen Kontakte ausgesetzt sind. Da somit nur das Silizium-Substrat 1 mit dem Druckmedium in Kontakt kommt, ist dies eine besonders medienresistente und partikelunempfindliche Ausführungsform.

Optional können die Elektrodenstrukturen 7a und 7b, 7c durch eine Schutzkappe 30 vor Schmutz, Flüssigkeiten, Feuchtigkeit oder sonstigen Partikeln geschützt werden. Die Schutzkappe 30 kann beispielsweise durch Kleben oder Löten - vorteilhafterweise im Waferverbund - aufgebracht werden. In dem durch die Schutzkappe eingeschlossenen Volumen kann ein Vakuum vorgesehen werden, so dass man einen Absolutdrucksensor erhält. Eine Alternative besteht darin, in der Schutzkappe 30 ein oder mehrere Druckzugangslöcher (nicht gezeigt) einzubauen. Dadurch erhält man einen Relativ- oder Differenzdrucksensor.

Fig. 4 ist eine Querschnittsansicht einer mikromechanischen Drucksensorvorrichtung gemäß einer dritten Ausführungsform der vorliegenden Erfindung.

Bei der in Fig. 4 gezeigten dritten Ausführungsform sind die bewegliche erste Elektrodenstruktur 7a' und die feststehende zweite Elektrodenstruktur 7b', 7c' auf der Rückseite R des Substrats 1 vorgesehen. Insbesondere ist unter der Membran M' im Membranbereich MB' ein weiteres n⁺-dotiertes Gebiet 3c herrührend vom APSM-Prozess vorgesehen, welches mit der Unterseite U' der Membran M' verbunden ist.

Durch einen rückseitigen Trenchprozess ist ein kreisförmiger Durchgang 12' um einen aus Substratmaterial bestehenden Pfosten 9a gebildet, welcher mit dem n⁺-dotierten Gebiet 3c verbunden ist. So lässt sich die Verankerung der ersten Elektrodenstruktur mittels eines Pfostens 9b, der mit dem Pfosten 9a verbunden ist, von der Rückseite R her an der Unterseite U' der Membran M' realisieren. Der externe Druck P wirkt bei dieser Ausführungsform auf die Oberseite O' der Membran M'.

Der Aufbau der aus der zweiten leitfähigen Polysiliziumschicht 7' strukturierten ersten Elektrodenstruktur 7a' bzw. zweiten Elektrodenstruktur 7b', 7c' ist identisch mit derjenigen bei der oben beschriebenen ersten bzw. zweiten Ausführungsform.

Ein Vorteil bei dieser Ausführungsform liegt darin, dass sie ebenfalls medienresistent gestaltet werden kann, weil die Druckbeauflagung mit dem externen Druck P von oben her erfolgt und die Elektrodenstrukturen 7a bzw. 7a' bzw. 7b', 7c' geschützt sind, da sie auf der Rückseite R des Substrats 1 angeordnet sind. Ein weiterer Vorteil besteht darin, dass das Druckmedium auf eine plane, glatte Oberseite O' der Membran M' geleitet werden kann, so dass ein Verhaken von Partikeln, Eis o. ä. verhindert werden kann. Eine weitere Besonderheit liegt darin, dass diese dritte Ausführungsform eine mechanische Durchkontaktierung durch das Substrat 1 aufweist. Eine elektrische Durchkontaktierung wäre weit aufwändiger und teurer aufgrund der zusätzlichen Metallisierung im Durchkontaktierungsbereich.

Bei der Herstellung erfolgt der Trenchprozess zur Herstellung des Pfostens 9a aus Substratmaterial zweckmäßigerweise nach Herstellung der Membran M' und vor Herstellung der Elektrodenstrukturen 7a' bzw. 7b', 7c', wobei der Trench in der Tiefe prozessbedingt breiter wird.

Wie bei der zweiten Ausführungsform kann ebenfalls eine Kappe auf der Vorderseite V des Substrats 1 mit einem entsprechenden Referenzvolumen aufgebracht werden, so dass auch bei dieser dritten Ausführungsform Absolut-, Relativ- und Differenzdrucksensoren realisierbar sind.

Bevorzugte Anwendungsgebiete der oben beschriebenen Drucksensoren sind Ansaugdrucksensor, Ladedrucksensor, Öldrucksensor, Benzindrucksensor, ..., was die Anwendungen im Automobilbereich betrifft.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere ist die Erfindung nicht nur auf mikromechanische Drucksensorvorrichtungen anwendbar, sondern auf beliebige mikromechanische Bauelemente mit einem Membranbereich zur Erfassung beliebiger physikalischer Größen.

Obwohl die oben beschriebenen Ausführungsformen Silizium für die Membranschicht bzw. Elektrodenschicht und Oxid für die Verankerungsschicht verwenden, ist die vorliegende Erfindung nicht darauf beschränkt. Vielmehr können für die leitfähigen Schichten beliebige leitfähige Materialien und die isolierenden Schichten beliebige isolierende Materialien verwendet werden. Auch ist die vorliegende Erfindung nicht auf das im Zusammenhang mit der Membran beispielhaft angeführte APSM-Verfahren beschränkt, sondern für beliebige Membran-Herstellungsverfahren geeignet.

## Patentansprüche

1. Mikromechanisches Bauelement mit:
einem Substrat (1) mit einer Vorderseite (V) und einer Rückseite (R), welches auf der Vorderseite (V) einen von einer Membran (M; M') überspannten Hohlraum (10) aufweist;
einer auf der Membran (M; M') verankerten ersten Elektrodenstruktur (7a; 7a'), welche eine Oberseite (O; O') und eine Unterseite (U; U') aufweist;
einer auf dem Substrat (1) seitlich zur Membran (M; M') versetzt verankerten zweiten Elektrodenstruktur (7b, 7c; 7b', 7c');
wobei eine Auslenkung der Membran (M; M') eine Verschiebung der ersten Elektrodenstruktur (7a, 7a') gegenüber der zweiten Elektrodenstruktur (7b, 7c; 7b', 7c') senkrecht zur Ebene der beiden Elektrodenstrukturen bewirkt, was zu einer Veränderung der Kapazität zwischen beiden Elektrodenstrukturen führt,
**dadurch gekennzeichnet, dass**
die erste Elektrodenstruktur (7a) an einem Pfosten (9) verankert ist, der auf der Oberseite (O) der Membran (M) angebracht ist, und wobei die zweite Elektrodenstruktur (7b, 7c) auf der Vorderseite (V) des Substrats (1) verankert ist

2. Mikromechanisches Bauelement nach Anspruch 1, wobei der Pfosten (9) in der Mitte der Oberseite (O) der Membran (M) angebracht ist.

3. Mikromechanisches Bauelement nach einem der vorhergehenden Ansprüche, wobei die erste Elektrodenstruktur (7a; 7a') eine Mehrzahl von ersten Elektrodenfingern (70a) aufweist, und die zweite Elektrodenstruktur (7b, 7c; 7b', 7c') eine Mehrzahl von zweiten Elektrodenfingern (70b, 70c) aufweist und wobei die ersten Elektrodenfinger (70a) zwischen den zweiten Elektrodenfingern (70b, 70c) angeordnet sind.

4. Mikromechanisches Bauelement nach Anspruch 1 oder 2, wobei sich eine Durchgangsöffnung (12) durch das Substrat (1) zur Rückseite (R) erstreckt, durch die externer Druck (P) an die Membran (M) anlegbar ist.

5. Mikromechanisches Bauelement nach einem der vorhergehenden Ansprüche, wobei eine Schutzkappe (30) auf der Vorderseite (V) über der ersten Elektrodenstruktur (7a, 7a') und der zweiten Elektrodenstruktur (7b, 7c; 7b', 7c') vorgesehen ist.

6. Mikromechanisches Bauelement nach einem der vorhergehenden Ansprüche, wobei die Membran (M; M') aus einer ersten leitfähigen Schicht (5) gebildet ist, die erste Elektrodenstruktur (7a, 7a') und die zweite Elektrodenstruktur (7b, 7c; 7b', 7c') aus einer zweiten leitfähigen Schicht (7) gebildet sind und die zweite Elektrodenstruktur (7b, 7c; 7b', 7c') über eine zwischen der ersten und zweiten leitfähigen Schicht (5; 7) befindliche isolierende Schicht (6) verankert ist.

7. Mikromechanisches Bauelement nach einem der vorhergehenden Ansprüche, wobei die erste Elektrodenstruktur (7a, 7a') und die zweite Elektrodenstruktur (7b, 7c; 7b', 7c') derart vom Substrat (1) beabstandet, dass es bei einer Druckbeaufschlagung knapp oberhalb eines Messbereichs zu einem Aufliegen entweder der ersten Elektrodenstruktur (7a, 7a') auf dem Substrat (1) oder der zweiten Elektrodenstruktur (7b, 7c; 7b', 7c') auf der Membran (M) kommt.

8. Mikromechanisches Bauelement nach einem der vorhergehenden Ansprüche, welches als Drucksensor ausgestaltet ist und aus der Veränderung der Kapazität zwischen der ersten Elektrodenstruktur (7a, 7a') und der zweiten Elektrodenstruktur (7b, 7c; 7b', 7c') ein elektrisches Drucksignal erzeugt.

9. Verfahren zur Herstellung eines mikromechanischen Bauelements nach Anspruch 1 mit den Schritten:
Bilden einer ersten leitfähigen Schicht (5) über einem Hohlraum (10) auf einer Vorderseite (V) eines Substrats (1), wodurch der Hohlraum (10) mit einer Membran (M) überspannt wird;
Bilden einer isolierenden Schicht (6) auf der ersten leitfähigen Schicht (5);
Bilden einer zweiten leitfähigen Schicht (7) über der isolierenden Schicht (6);
Bilden eines Pfostens (9) zum Verankern der zweiten leitfähigen Schicht (7) auf einer Oberseite (O) der Membran (M);
Bilden einer ersten Elektrodenstruktur (7a) und einer zweiten Elektrodenstruktur (7b, 7c) aus der zweiten leitfähigen Schicht (7); und
Entfernen der isolierenden Schicht (6) unter der ersten Elektrodenstruktur (7a), wobei die isolierende Schicht (6) teilweise unter der zweiten Elektrodenstruktur (7b, 7c) verbleibt, um die zweite Elektrodenstruktur (7b, 7c) auf der Vorderseite (V) des Substrats (1) seitlich zur Membran (M) versetzt zu verankern.

## Claims

1. Micromechanical component comprising:
a substrate (1) having a front side (V) and a rear side (R), said substrate having on the front side (V) a cavity (10) spanned by a membrane (M; M');
a first electrode structure (7a; 7a') anchored on the membrane (M; M') and having a top side (O; O') and an underside (U; U');
a second electrode structure (7b, 7c; 7b', 7c') anchored on the substrate (1) in a manner offset laterally with respect to the membrane (M; M');
wherein a deflection of the membrane (M; M') brings about a displacement of the first electrode structure (7a, 7a') relative to the second electrode structure (7b, 7c; 7b', 7c') perpendicularly to the plane of the two electrode structures, which leads to a change in the capacitance between both electrode structures,
**characterized in that**
the first electrode structure (7a) is anchored to a post (9) fitted on the top side (O) of the membrane (M), and wherein the second electrode structure (7b, 7c) is anchored on the front side (V) of the substrate (1) .

2. Micromechanical component according to Claim 1, wherein the post (9) is fitted in the centre of the top side (O) of the membrane (M).

3. Micromechanical component according to either of the preceding claims, wherein the first electrode structure (7a; 7a') has a plurality of first electrode fingers (70a), and the second electrode structure (7b, 7c; 7b', 7c') has a plurality of second electrode fingers (70b, 70c), and wherein the first electrode fingers (70a) are arranged between the second electrode fingers (70b, 70c).

4. Micromechanical component according to Claim 1 or 2, wherein a through opening (12) extends through the substrate (1) to the rear side (R), through which external pressure (P) can be applied to the membrane (M).

5. Micromechanical component according to any of the preceding claims, wherein a protective cap (30) is provided on the front side (V) above the first electrode structure (7a, 7a') and the second electrode structure (7b, 7c; 7b', 7c').

6. Micromechanical component according to any of the preceding claims, wherein the membrane (M; M') is formed from a first conductive layer (5), the first electrode structure (7a, 7a') and the second electrode structure (7b, 7c; 7b', 7c') are formed from a second conductive layer (7), and the second electrode structure (7b, 7c; 7b', 7c') is anchored by way of an insulating layer (6) situated between the first and second conductive layers (5; 7).

7. Micromechanical component according to any of the preceding claims, wherein the first electrode structure (7a, 7a') and the second electrode structure (7b, 7c; 7b', 7c') are spaced apart from the substrate (1) in such a way that in the event of application of pressure just above a measurement range either the first electrode structure (7a, 7a') bears on the substrate (1) or the second electrode structure (7b, 7c; 7b', 7c') bears on the membrane (M).

8. Micromechanical component according to any of the preceding claims, which is configured as a pressure sensor and generates an electrical pressure signal from the change in the capacitance between the first electrode structure (7a, 7a') and the second electrode structure (7b, 7c; 7b', 7c').

9. Method for producing a micromechanical component according to Claim 1 comprising the following steps:
forming a first conductive layer (5) above a cavity (10) on a front side (V) of a substrate (1), as a result of which the cavity (10) is spanned with a membrane (M);
forming an insulating layer (6) on the first conductive layer (5);
forming a second conductive layer (7) above the insulating layer (6);
forming a post (9) for anchoring the second conductive layer (7) on a top side (O) of the membrane (M);
forming a first electrode structure (7a) and a second electrode structure (7b, 7c) from the second conductive layer (7); and
removing the insulating layer (6) below the first electrode structure (7a), wherein the insulating layer (6) remains partly below the second electrode structure (7b, 7c) in order to anchor the second electrode structure (7b, 7c) on the front side (V) of the substrate (1) in a manner offset laterally with respect to the membrane (M).

## Revendications

1. Composant micromécanique présentant :
un substrat (1) doté d'un côté avant (V) et d'un côté arrière (R) et qui présente sur le côté avant (V) une cavité (10) recouverte par une membrane (M; M'),
une première structure d'électrode (7a, 7a') ancrée sur la membrane (M; M') et qui présente un côté supérieur (O; O') et un côté inférieur (U; U'),
une deuxième structure d'électrode (7b, 7c; 7b', 7c') ancrée sur le substrat (1) et décalée latéralement par rapport à la membrane (M; M');
une déformation de la membrane (M; M') ayant pour effet un déplacement de la première structure d'électrode (7a, 7a') par rapport à la deuxième structure d'électrode (7b, 7c; 7b', 7c') perpendiculairement au plan des deux structures d'électrode, ce qui conduit à une modification de la capacité qui prévaut entre les deux structures d'électrode,
**caractérisé en ce que**
la première structure d'électrode (7a) est ancrée sur une colonne (9) placée sur le côté supérieur (O) de la membrane (M), et **en ce que** la deuxième structure d'électrode (7b, 7c) est ancrée sur le côté avant (V) du substrat (1).

2. Composant micromécanique selon la revendication 1, dans lequel la colonne (9) est placée au milieu du côté supérieur (O) de la membrane (M).

3. Composant micromécanique selon l'une des revendications précédentes, dans lequel la première structure d'électrode (7a; 7a') présente plusieurs premiers doigts d'électrode (70a), la deuxième structure d'électrode (7b, 7c; 7b', 7c') présentant plusieurs deuxièmes doigts d'électrode (70b, 70c), les premiers doigts d'électrode (70a) étant disposés entre les deuxièmes doigts d'électrode (70b, 70c).

4. Composant micromécanique selon les revendications 1 ou 2, dans lequel une ouverture de passage (12) par laquelle la pression extérieure (P) peut être appliquée sur la membrane (M) traverse le substrat (1) jusqu'au côté arrière (R).

5. Composant micromécanique selon l'une des revendications précédentes, dans lequel un capuchon de protection (30) est prévu sur le côté avant (V) au-dessus de la première structure d'électrode (7a, 7a') et la deuxième structure d'électrode (7b, 7c; 7b', 7c').

6. Composant micromécanique selon l'une des revendications précédentes, dans lequel la membrane (M; M') est formée d'une première couche conductrice (5), la première structure d'électrode (7a, 7a') et la deuxième structure d'électrode (7b, 7c; 7b', 7c') sont formées d'une deuxième couche conductrice (7) et la deuxième structure d'électrode (7b, 7c; 7b', 7c') est ancrée par l'intermédiaire d'une couche isolante (6) située entre la première et la deuxième couche conductrice (5; 7).

7. Composant micromécanique selon l'une des revendications précédentes, dans lequel la première structure d'électrode (7a, 7a') et la deuxième structure d'électrode (7b, 7c; 7b', 7c') sont maintenues à distance du substrat (1) de telle sorte que lorsqu'une pression est appliquée exactement au-dessus d'une zone de mesure, la première structure d'électrode (7a, 7a') vient se placer sur le substrat (1) ou la deuxième structure d'électrode (7b, 7c; 7b', 7c') vient se placer sur la membrane (M).

8. Composant micromécanique selon l'une des revendications précédentes, configuré comme capteur de pression et formant un signal électrique de pression à partir de la modification de la capacité qui prévaut entre la première structure d'électrode (7a, 7a') et la deuxième structure d'électrode (7b, 7c; 7b', 7c').

9. Procédé de fabrication d'un composant micromécanique selon la revendication 1, le procédé présentant les étapes suivantes :
formation d'une première couche conductrice (5) au-dessus d'une cavité (10) ménagée sur le côté avant (V) d'un substrat (1), ce qui recouvre la cavité (10) par une membrane (M),
formation d'une couche isolante (6) sur la première couche conductrice (5),
formation d'une deuxième couche conductrice (7) au-dessus de la couche isolante (6),
formation d'une colonne (9) qui ancre la deuxième couche conductrice (7) sur le côté supérieur (O) de la membrane (M),
formation d'une première structure d'électrode (7a) et d'une deuxième structure d'électrode (7b, 7c) sur la deuxième couche conductrice (7) et enlèvement de la couche isolante (6) en dessous de la première structure d'électrode (7a), la couche isolante (6) restant partiellement en dessous de la deuxième structure d'électrode (7b, 7c) pour ancrer la deuxième structure d'électrode (7b, 7c) sur le côté avant (V) du substrat (1) en décalage latéral par rapport à la membrane (M).
